Europäisches Patentamt

European Patent Office

Office européen des brevets

(19)

(11) **EP 0 864 205 B1**

(12) **EUROPEAN PATENT SPECIFICATION**

(45) Date of publication and mention
of the grant of the patent:
**03.04.2002 Bulletin 2002/14**

(21) Application number: **96941269.1**

(22) Date of filing: **27.11.1996**

(51) Int Cl.$^7$: **H03M 7/16**

(86) International application number:
**PCT/SE96/01555**

(87) International publication number:
**WO 97/20395 (05.06.1997 Gazette 1997/24)**

(54) **A METHOD AND AN ARRANGEMENT FOR MAKING FIXED LENGTH CODES**

VERFAHREN UND VORRICHTUNG ZUR GENERIERUNG VON CODEWÖRTERN FESTER WORTLÄNGE

PROCEDE ET DISPOSITIF POUR REALISER DES CODES DE LONGUEUR FIXE

(84) Designated Contracting States:
**DE FR GB SE**

(30) Priority: **29.11.1995 SE 9504270**
**29.11.1995 US 7614 P**

(43) Date of publication of application:
**16.09.1998 Bulletin 1998/38**

(73) Proprietor: **TELEFONAKTIEBOLAGET L M**
**ERICSSON (publ)**
**126 25 Stockholm (SE)**

(72) Inventor: **BANG, Karl, Göran**
**S-175 48 Järfälla (SE)**

(74) Representative: **Lövgren, Tage et al**
**Ericsson Radio Systems AB,**
**Patent Support, Legal Matters**
**Radio Systems and Technology**
**164 80 Stockholm (SE)**

(56) References cited:
**DE-C- 4 124 483          US-A- 4 975 698**
**US-A- 5 298 896          US-A- 5 300 930**

**Description**

**TECHNICAL FIELD**

The present invention relates to a method of making fixed length codes more robust against bit errors. The invention also relates to an arrangement for carrying out the method.

**DESCRIPTION OF THE BACKGROUND ART**

Events can be coded in binary code words, A binary encoding method with substantially uniform rate is shown in the US patent US 5,300,930. Often one wants to code the information in as few bits as possible in order to minimise the bandwidth required. Depending on the probability distribution of the events it is possible to code the information in such a way that events that occur rarely are coded with longer code words and events that occur frequently are coded with shorter code words and the encoding is done so that the decoder can distinguish between the different code words. Such codes are called instantaneous.

Very efficient codes can be designed in this way and the method of coding is called entropy coding.

However, assume that the transmission channel between the encoder and decoder introduces bit errors. In this case problems arise because the decoder cannot with certainty decode the different variable length code words since it is not possible to see where one code word starts and another ends. Of course, this can have a devastating effect on the interpretation of the received information.

Usually this problem is solved by means of channel coding, where controlled redundancy is introduced in the channel encoder in such a way that the channel decoder can detect and correct erroneous bits.

Using this method more bits have to be transmitted over the channel and the channel bit rate increases as well as the complexity due to the channel encoder and decoder. Moreover, at bit error rates that are higher than the error correcting capacity of the channel coding, the decoded bit error rate often becomes worse than the uncoded bit error rate. Such a threshold exists for every code, either limited by the Shannon capacity formula or on a restriction in acceptable delay due to channel coding.

One way to overcome some of the drawbacks with a variable length code, in terms of bit error robustness, is to use a fixed length code. Here we lose some efficiency because all code words have the same length independent of the probability distribution of the events to be coded. However, once synchronised, each code word can be decoded independent of any other code word and this makes the code rather robust.

If we assume that the information to be transmitted represents a 'level' monotonically increasing from a minimum value to a maximum value the events represent discrete points on this level curve and each point is coded with a fixed length code word.

A bit error in a code word causes a jump in the level curve and dependent on which bit in the code word that is erroneous, the level jump becomes smaller or larger. This means that some bit errors (at certain positions in the code word) may cause an acceptable decoded level (small level error) while other error bits in a code word cause a totally unacceptable level change.

The common way to improve the robustness to bit errors of a fixed length code table is by means of Gray coding is to be found in the following two books:

[1] John A.C. Bingham, "The Theory and Practice of Modem Design", John Wiley & Sons, 1988 (pp. 65-66).

[2] E.A.Lee, D.G. Messerschmitt, "Digital Communication", Kluwer Academic Publishers Boston, 1988 (pp. 193).

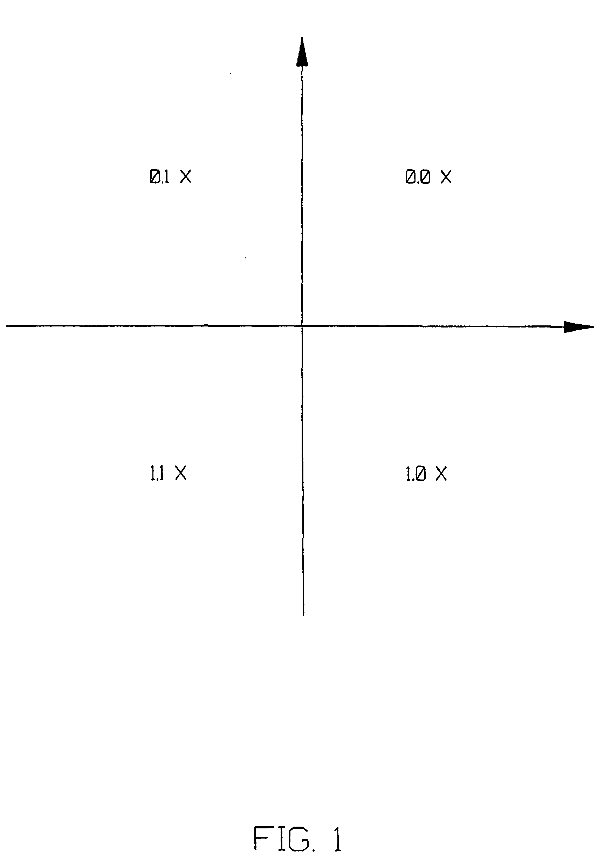

A well known method to decrease the bit error sensitivity of a fixed length code is by means of Gray coding which is shown in figure 1. Gray codes have the property that nearest neighbours are encoded into code words that differ by only one bit, i.e. the Hamming distance is 1. This works fine for a 2-bit code (4 words) in a 2-dimensional signal constellation, where also the Euclidean distance is at a minimum for code words with Hamming distance =1.

In a 1-dimensional representation, when the code words represent a level, the situation is different, as illustrated with the following 3-bit codes with 8 levels.

A straight forward code and two Gray codes with associated bit error distances are shown in Table 1. The distance $d1$ is the sum of the distances obtained by changing one bit at a time in the code word. The mean distance per bit is then $d1 / 3$ units.

US 5300930 A relates to a binary coding method according to which as few bits as possible should change from one code word to another on the average. Since few bits are changed the lifetimes of E2PROMs used in coders and encoders are prolonged. This has nothing in common with the present applicant's invention, wherein several bits

**EP 0 864 205 B1**

may change in adjacent code words that are positioned far away from the kernel.

Table 1.

| Level | Straight Code | | Gray Code 1 | | Gray Code 2 | |
|---|---|---|---|---|---|---|
| | Code | Distance d1 | Code | Distance d1 | Code | Distance d1 |
| 0 | 000 | 4+2+1=7 | 000 | 5+1+3=9 | 000 | 3+1+7=11 |
| 1 | 001 | 4+2+1=7 | 010 | 5+1+1=7 | 010 | 1+1+5=7 |
| 2 | 010 | 4+2+1=7 | 011 | 5+1+1=7 | 110 | 1+1+3=5 |
| 3 | 011 | 4+2+1=7 | 001 | 1+1+3=5 | 100 | 3+1+1=5 |
| 4 | 100 | 4+2+1=7 | 101 | 1+3+1=5 | 101 | 3+1+1=5 |
| 5 | 101 | 4+2+1=7 | 100 | 5+1+1=7 | 111 | 1+1+3=5 |
| 6 | 110 | 4+2+1=7 | 110 | 5+1+1=7 | 011 | 1+1+5=7 |
| 7 | 111 | 4+2+1=7 | 111 | 5+3+1=9 | 001 | 3+1+7=11 |

Using a metric based upon the Euclidean distance, d1, or the squared Euclidean distance, d2, we can define the following distances

$$\varepsilon 1 = \frac{1}{n} \sum_{m=0}^{M-1} p(m)\, d1(m)$$

and

$$\varepsilon 2 = \frac{1}{n} \sum_{m=0}^{M-1} p(m)\, d2(m)$$

where

n is the number of bits in code word,
M is the number of code words,
p(m) is the pdf (probability density function) of the level, m = 0, 1, ..., M-1,
$\varepsilon 1$ is the mean error distance per bit and
$\varepsilon 2$ is the mean squared distance (mse) per bit.

The mean error distance per bit is $\varepsilon 1$ = 7/3 = 2.33 units for all three codes. Thus, for a *uniform pdf* for the level, nothing is gained with a Gray code compared with the straight code. However, if the levels 3 and 4 (2,3,4 and 5) are more common than the other levels a gain of the Gray code 1 (Gray code 2) in the mean error distance is achieved.

## SUMMARY OF THE INVENTION

This invention is about how to make fixed length codes more robust against bit errors, in cases when the probability density function (pdf) has a peak (not uniformly distributed). A considerable gain in mean squared error (mse) can be achieved in these cases, and the actual gain depends on the number of bits in the code word and the actual pdf of the level.

PROBLEM DESCRIPTION

Introducing a bit error in the straight code in Table 1, the level jump may be 1, 2 or 4 units depending on the position of the erroneous bit. This is valid for each of the 8 code words and the mean error distance is $\varepsilon 1$ = 7/3 = 2.33

3

units per bit. If the mse is used, the figure becomes $\varepsilon2 = (1^2 + 2^2 + 4^2)/3 = 7$ units$^2$ per bit. These values on $\varepsilon1$ and $\varepsilon2$ are independent of the actual pdf, and therefore this straight code may serve as a reference for other codes.

Assuming a uniform pdf for the Gray code 1 we get a mean error distance of $\varepsilon1 = 2*(9+7+7+5)/(8*3) = 7/3 = 2.33$ units per bit which is equal to the straight coding. The mse becomes $\varepsilon2 = 25/3 = 8.33$ units$^2$ per bit.

The corresponding figures for the Gray code 2 are; mean error distance $\varepsilon1 = 7/3 = 2.33$ units per bit and mse $\varepsilon2 = 27/3 = 9$ units$^2$ per bit.

Thus, nothing is gained by using Gray coding compared to straight coding if the level pdf is uniform. On the contrary, if mse is chosen as the metric there is a performance loss.

However, if we have a pdf with a peak in the central part of the coding table a performance gain can be anticipated with the Gray code tables.

Still, the *minimum distance* and the *minimum squared distance* are for the Gray code tables 5/3 = 1.67 units per bit and 11/3 = 3.67 units$^2$ per bit, respectively, and these values may be too large to be acceptable and they do not represent the minimum values that can be achieved.

Sometimes the pdf does not have a peak at the central part but may have another shape, for example, two peaks on either side of the central part of the level curve. To cope with this situation another design method is required to build a bit error robust fixed length code table.

The chrominance (colour difference) components represented by the fixed length tables usually have a very pronounced peak, therefore the invented code should be suitable for improving the robustness to bit errors in this context.

## BEST MODES OF CARRYING OUT THE INVENTION

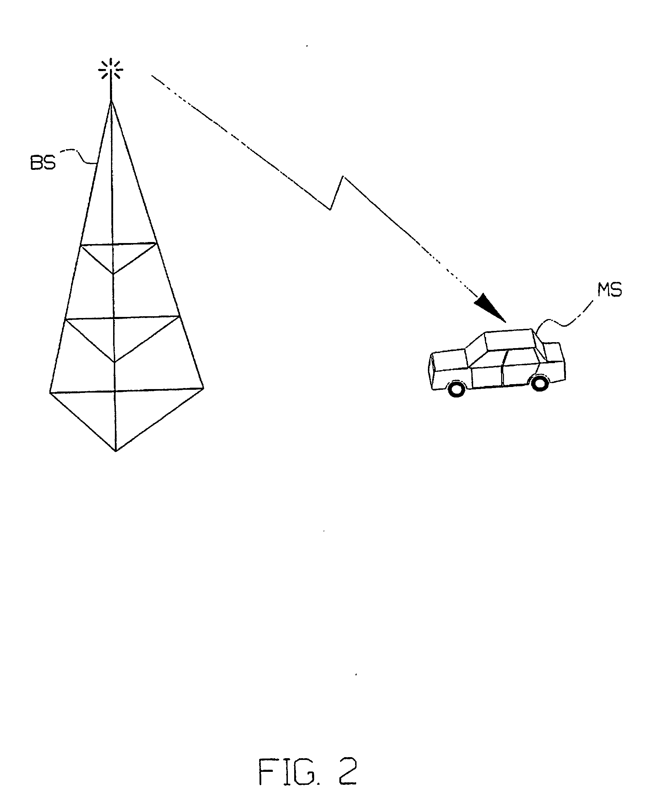

A mobile telephone radio communication system is shown in figure 2. A radio base station BS transmits information to and from a mobile radio terminal MS. The radio connection is shown in the figure as a zig-zag symbol between the radio base station BS and the mobile radio terminal MS.

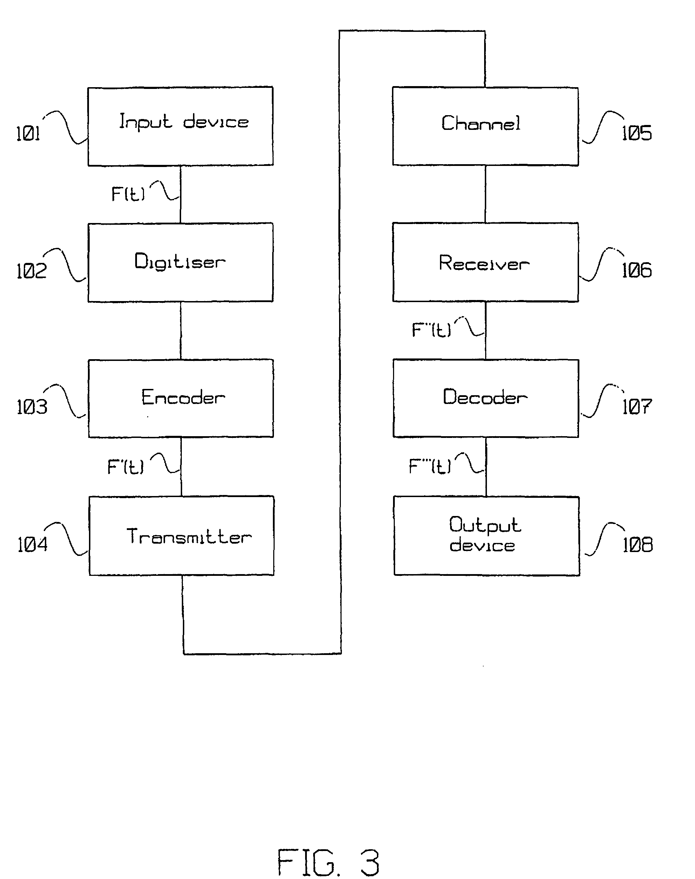

Figure 3 is a flow chart illustrating how information is transferred from the radio base station BS to the mobile radio terminal MS of figure 2. A block 101 illustrates an input device which in the embodiment is e.g. a video camera connected to the radio base station shown in figure 2. A block 102 illustrates a digitiser connected to the input device. An encoder 103 is in accordance with the invention connected to the digitiser. A transmitter is illustrated with block 104. The blocks 102-104 are parts of the radio base station BS. Block 105 illustrates the channel on which information is transmitted from the radio base station BS to the mobile radio terminal MS. The channel is a radio channel of 9.6 kbits/s disturbed by e.g. Rayleigh fading. Block 106 illustrates a receiver situated in the mobile radio terminal MS and a decoder is illustrated by block 107. Block 108 symbolises e.g. a video monitor. The input device 101 comprises an information source that generates a variable that is a function of time F(t), wherein a probability density function for values of F(t) occurring in said information source has a maximum. The digitiser 102 and the encoder 103 of the function F(t) perform digitisation and encoding of F(t) into a function F'(t) by using a table such that the Hamming distance between code words of F'(t) that are adjacent to one another is lower for values of F(t) that are near the maximum of the probability density function than for values of F(t) that are further away from said maximum. The transmitter 104 transmits the information in the function F'(t) over the channel 105. The information is received by the receiver 106 as F"(t) because F'(t) has been disturbed by Rayleigh fading in the channel 105. The decoder 107 decodes the received function F"(t) back into a function F'"(t) which is similar to the original function F(t), by using a table which is the inverse of the table in the encoder 103.

The earlier mentioned Gray code is characterised by the fact that the Hamming distance for a code word to the closest neighbours is one. If the code represents a level monotonically increasing from a minimum value to a maximum value the Hamming distance may not be the proper metric to use for a robust code design. Rather, one should use a metric that reflects the *level change* when the different bits in a code word change, such as the Euclidean distance or the squared Euclidean distance (the mse).

The design method for the pdf with a peak is illustrated with a 3 bit code table, the so called Baang-1 code. We assume that we know the pdf or at least the position of the peak of the pdf representing the level curve.

The other code design method, suitable for more general pdf:s is illustrated by a 4 bit code table, the so called Baang-2 code.

### 7.1 Pdf with a peak (Baang-1 code)

Here we want to minimise the distances for code words taken from a particular code word, hereafter denoted the *kernel,* and outwards. The code words are taken in an order of increasing distance from the kernel.

### 7.1.1) Initialise the code table.

7.1.1.a) Pick the kernel, for example 111, and put it on that level position that corresponds to the peak of the level pdf, in our case, say level 3.

| Level | Code Word |
|---|---|
| 3 | 111 (kernel) |

7.1.1.b) On either side of the kernel, insert two new code words with the Hamming distance one to the kernel. In this case we change the leftmost bit first and then the next bit in order. However, any order of bitchange can be used.

| Level | Code Word | Distance d1 |
|---|---|---|
| 2 | 011 | |
| 3 | 111 | 1+1+?=? |
| 4 | 101 | |

7.1.1.c) The third bit, the rightmost bit of the kernel, is now changed and the new code word is put on level 1 (or level 5)

| Level | Code Word | Distance d1 | d2 |
|---|---|---|---|
| 1 | 110 | | |
| 2 | 011 | | |
| 3 | 111 | $1 + 1 + 2 = 4$ | $1^2 + 1^2 + 2^2 = 6$ |
| 4 | 101 | | |

With this initialisation we have packed all code words with the Hamming distance one as close as possible (in the Euclidean distance sense) to the kernel.
Should there be more than 3 bits in the code words, say n bits, the same procedure is applied and the result is an initialisation of (n+1) code words.

### 7.1.2) Continue to build the table.

7.1.2.a) The next code word to consider is the one closest to the kernel and with the maximum degree of freedom to design new code words in a compact way.
Level 2 with the code word 011 has code words on each side, but level 4 with the code word 101 has a code word only on one side (111), and thus has the maximum degree of freedom. This code word (101) is called the 1 :st reference.
Thus, changing the bits in the 1 :st reference we get the following table: (here we use the same order for changing bits as was used in the initialisation, but any other order can be used as well)

| Level | Code Word | Distance d1 | d2 |
|---|---|---|---|
| 1 | 110 | | |
| 2 | 011 | | |
| 3 | 111 | 1+1+2=4 | 6 |
| 4 --> | 101 | 1+1+2=4 | 6 |
| 5 | 001 | | |
| 6 | 100 | | |

If not the bit changed code word is in the table we add it as close as possible to the reference word.
7.1.2.b) Following the principle in 2a) we now consider level 2 and choose code word 011 as the 2:nd reference and get

| Level | Code Word | Distance d1 | d2 |
|---|---|---|---|
| 0 | 01*0* | | |
| **1** | 110 | | |
| **2 -->** | 011 | 1+3+2=6 | 14 |
| **3** | **111** | 1+1+2=4 | 6 |
| **4** | 101 | 1+1+2=4 | 6 |
| 5 | 001 | | |
| 6 | 100 | | |

7.1.2.c) For the next reference to consider (110 or 001) there is no difference in the distance to the kernel and the number of freedom is the same and so 2a) does not give us the information how to proceed and any side can be used.

In this example we stick to the symmetry principle and process that code word that is on the opposite side of the kernel of the last processed code word.

In this case it means level 5 with the reference word 001, and the result is

| Level | Code Word | Distance d1 | d2 |
|---|---|---|---|
| 0 | 010 | | |
| 1 | 110 | | |
| **2** | 011 | 1+3+2=6 | 14 |
| **3** | **111** | 1+1+2=4 | 6 |
| **4** | 101 | 1+1+2=4 | 6 |
| **5 -->** | 001 | 1+3+2=6 | 14 |
| 6 | 100 | | |
| 7 | 00*0* | | |

7.1.3) All 8 code words are now associated with a level and we just calculate the distance d1(m) and mse d2 (m) for the remaining 4 code words.

Table 2 shows the final result, the 3 bit Baang-1 code.

Table 2.

| | **Straight Code** | | **Baang-1 Code** | | |
|---|---|---|---|---|---|
| | **Code** | **Distance** | **Code** | **Distance** | |
| | | **d1** | | **d1** | **d2** |
| **0** | 000 | 4+2+1=7 | 010 | 1+7+2=10 | 54 |
| **1** | 001 | 4+2+1=7 | 110 | 1+5+2=8 | 30 |
| **2** | 010 | 4+2+1=7 | 011 | 1+3+2=6 | 14 |
| **3** | 011 | 4+2+1=7 | 111 | 1+1+2=4 | 6 |
| **4** | 100 | 4+2+1=7 | 101 | 1+1+2=4 | 6 |
| **5** | 101 | 4+2+1=7 | 001 | 1+3+2=6 | 14 |
| **6** | 110 | 4+2+1=7 | 100 | 1+5+2=8 | 30 |
| **7** | 111 | 4+2+1=7 | 000 | 1+7+2=10 | 54 |

As can be seen from the table, the distance d2 for the straight code is 21 for each code word.

### 7.1.3) Termination of the table.

If a new code word designed from a reference and allocated according to the principles outlined above falls outside one of the end levels, a reference word from the other side of the kernel is used. This may happen, for example , when the peak of the pdf is not in the central part of the level distribution. The following example illustrates the principle, where we assume that the peak of the pdf is located at level 5.

| | Step 1 | Step 2 | Step 3 | Step 4 | |
|---|---|---|---|---|---|
| Level | Code | Code | Code | Code | Distance d1 |
| 0 | | | | 000 | 1+1+4=6 |
| 1 | | | 10*0* | 100 | 1+6+5=12 |
| 2 | | 010 | 010 | 010 | 5+2+2=9 |
| 3 | | 001 | *001* --> | 001 | 3+1+3=7 |
| 4 | --> | *0*11 | 011 | 011 | 1+1+2=4 |
| 5 | **111** | **111** | **111** | **111** | 1+1+2=4 |
| 6 | | 1*01* --> | 101 | 101 | 3+1+5=9 |
| 7 | | 11*0* | 110 | 110 | 5+6+2=13 |

### 7.2 More general pdf (Baang-2 code).

This technique may be used when the pdf has a more general shape and the design steps are as follows. Here we illustrate the method by a 4 bit code (n=4).

### 7.2.1) Initialise the code table.

7.2.1.a) Pick a (n-1) bit code word, for example 111, denoted kernel, and put it on the level position that corresponds to the peak of the level pdf, say level 8.

| Level | Code Word |
|---|---|
| 8 | 111 |

7.2.1.b) Insert a maximum of (n-1) new code words with Hamming distance one from the kernel and put them on the distances $d = [d_1, d_2, ... d_k]$ units from the kernel, in our example we choose $d_1 = 1$, $d_2 = 3$ and $d_3 = 5$ and we get,

### 7.2.2) Continue to build the table.

7.2.2.a) The code table is built from the kernel and upwards and the code word associated with the distance $d_1$ is used as the 1:st reference, i.e. 110. (The index in the distance measure is taken as the order in which the references are processed).

Changing the bits in the 1 :st reference and packing the new words as close as possible to the kernel we get

| Level | Code Word |
|---|---|
| 3 | 011 |

(continued)

| Level | Code Word |
|---|---|
| 4 | 1*00* |
| 5 | 101 |
| **6** | *0*10 |
| **7 -->** | 110 |
| **8** | **111** |

Next we use the code word associated with $d_2$, 101, as a reference, changing the bits and obtain

| Level | Code Word |
|---|---|
| 2 | *0*01 |
| 3 | 011 |
| 4 | 100 |
| 5 --> | 101 |
| 6 | 010 |
| 7 | 110 |
| 8 | **111** |

Next reference corresponding to $d_3$, 011, does not give any new code word, and all the references have now been used.

2.2.2.b) With the code word next to the kernel as a reference, 110, change the bits and fill up the table with new code words in positions as close as possible to the kernel. In this case 110 does not give any new code word and so continue with the next code word counted from the kernel, namely 010.

| Level | Code Word |
|---|---|
| 1 | 0*00* |
| 2 | 001 |
| 3 | 011 |
| 4 | 100 |
| **5** | 101 |
| **6 -->** | 010 |
| **7** | 110 |
| **8** | **111** |

and we have all 8 code words.

7.2.2.c) To obtain the 16 possible code words for the 4 bit code we take the mirror picture of the 8 code words below the 8:th word (or above the 1 :st word) and put a 1 (or 0) at the leftmost position (or rightmost position or any position) of the 8 original words and a 0 (or 1) at the same bit position in the reflected 8 words,.i.e. one implementation gives

| Level | Code Word | Distance d1 |
|---|---|---|
| 1 | 1000 | 24 |
| 2 | 1001 | 18 |
| 3 | 1011 | 18 |
| 4 | 1100 | 16 |
| 5 | 1101 | 14 |
| 6 | 1010 | 12 |
| 7 | 1110 | 8 |
| 8 | 1111 | 10 |
| 9 | 0111 | 10 |

(continued)

| Level | Code Word | Distance d1 |
|---|---|---|
| 10 | 0110 | 8 |
| 11 | 0010 | 12 |
| 12 | 0101 | 14 |
| 13 | 0100 | 16 |
| 14 | 0011 | 18 |
| 15 | 0001 | 18 |
| 16 | 0000 | 24 |

The design method ensures a symmetrical distance distribution d1(m) and d2(m) and it allows a flexibility to adapt the distance distribution to the actual pdf of the level in such a way that a small distance is allocated to the peak (s) of the pdf, thereby making the mean error distance per bit $\varepsilon 1$ and the squared distance per bit $\varepsilon 2$ small.

Forbidden code words are removed from the table.

To illustrate the flexibility of the Baang-2 code methodology, we generate 2 different 4 bit code tables based on the two initialisation vectors $\mathbf{d_a}$ = [1 3 7) and $\mathbf{d_b}$ = [1 2 3] and this time we show the metric d2(m) (mse). The kernel is chosen to 111. See Table 3.

Table 3.

| Level m | Code $d_a$ | d2(m) | Code $d_b$ | d2(m) |
|---|---|---|---|---|
| 1 | 1011 | 287 | 1000 | 239 |
| 2 | 1000 | 190 | 1001 | 195 |
| 3 | 1001 | 130 | 1010 | 145 |
| 4 | 1010 | 103 | 1100 | 103 |
| 5 | 1101 | 63 | 1011 | 71 |
| 6 | 1100 | 43 | 1101 | 49 |
| 7 | 1110 | 20 | 1110 | 35 |
| 8 | 1111 | 60 | 1111 | 15 |
| 9 | 0111 | 60 | 0111 | 15 |
| 10 | 0110 | 20 | 0110 | 35 |
| 11 | 0100 | 43 | 0101 | 49 |
| 12 | 0101 | 63 | 0011 | 71 |
| 13 | 0010 | 103 | 0100 | 103 |
| 14 | 0001 | 130 | 0010 | 145 |
| 15 | 0000 | 190 | 0001 | 195 |
| 16 | 0011 | 287 | 0000 | 239 |

As a comparison a straigth code has d2(m) = 85 for each code word.

**7.3 Variations of code tables.**

The bit-columns of the code tables can be changed in any order without changing the metric (distance).

Ones can be exchanged by zeros and vice versa without changing the metric.

**Baang-1 code.**

The Baang-1 code gives the *minimum distance* (or mse) to code words with Hamming distance one, i.e. for code words with single bit errors, to the kernel.

Alternative code words on each side of the kernel are designed in such a way that the levels associated with the Hamming distance = 1 to the code word considered are minimised.

The kernel has the least possible distance (or mse) and the distance measure (or mse) increases further away from the kernel.

The Baang-1 code is particularly useful for representing information that has a peak in its pdf.

Although the design method has been described for a short 3-bit code, for the purpose of illustration, the same design principle is applicable for longer codes. Furthermore, the maximum gain compared to a straight code increases with the length of the code words.

**Baang-2 code.**

With this design method we have a possibility to adapt the error distances to the peak(s) of the pdf in such a way that small error distances are allocated to the peak(s) of the pdf. The way to control this allocation is by means of the initialisation process i.e. how we set the reference code words related to the kernel - the distances $d_1$, $d_2$, $d_3$, ... $d_k$, where $0 < k < n-1$ and where each d-component takes on distinct integer values in the interval $[1, 2^{(n-1)}-1]$. The d-values are put at positions where the pdf has high values.

Columns in the code table can be reordered in any order without changing the distance measures. Ones can be replaced by zeros and vice versa without changing the distance measures. The initialisation process can, of course, also generate new code words downwards (instead of upwards) and the code table can be generated in an apparent way based on the steps described above ( a symmetry principle).

The arrangement in accordance with the invention comprises means for allocating a new code word to the other side of the kernel in cases where the end of the code table has been reached on the side where said code word should be allocated according to previous steps. The arrangement also comprises means to stop new code word generation when all $2^n$ code words have been generated and means for removing not allowed code word(s), which with a suitable choice of the kernel as previously described, is (are) allocated towards the end(s) of the code table. A number of variations of the above mentioned embodiments are of course possible Bit-columns in the code table can e.g. be reordered in any order without changing the distance measures. Binary "ones" can be replaced by "zeros" and vice versa without changing the distance measures.

## Claims

1. A method for generating a robust fixed length code for encoding information in a telecommunication system **characterized by** initializing a code table by selecting a kernel code word, allocating the kernel code word to a position corresponding to a peak of a probability density function of the information, said kernel having n bits, generating n new code words, each new code-word having a Hamming distance one to said kernel, packing said new code words as close as possible on either side of the kernel in order to build said code table.

2. A method in accordance with claim 1, **characterized by** the further steps of:

   - continuing to build the table, where a first code word to consider, hereafter called the first reference word, is the code word closest to the kernel that either, when n is odd, is located on that side of the kernel that has the least number of initialised code words
     or, when n is even, is located on any side of the kernel;
   - generating n new code words with Hamming distance one to said first reference word and packing said n new code words, if not already in the table, as close as possible to the said first reference word.

3. A method in accordance with claim 2, **characterized by** the further steps of:

   - selecting a second reference word from the not yet selected side of the kernel and as close as possible to the kernel;
   - generating n new code words with Hamming distance one to said second reference word and packing said n new code words, if not already in the table, as close as possible to the said second reference word.

4. A method in accordance with claim 3, **characterized by** the further steps of:

   - repetitively selecting new reference words as close as possible to the kernel in an alternating order and increasing distance from the kernel;

- generating n new code words with Hamming distance one to current reference word and packing said n new code words, if not already in the table, as close as possible to the said current reference word.

5. A method in accordance with any of the previous claims, wherein less than $2^n$ code words are used for coding **characterized** selecting the kernel as the code word with the largest Hamming distance to the unused code words.

6. A method in accordance with claim 1, whereby the coded information is transmitted over a radio channel.

7. A method in accordance with claim 1 whereby the transmitted information is video information.

8. A method for generating a robust fixed length code for encoding information in a telecommunication system **characterized by**

- initializing a code table by selecting a kernel code word and assigning the kernel code word to an estimated or real symmetry line of a probability density function of the information,
- selecting the kernel arbitrarily as a (n-1) bit word, where n is the number of bits in a code word, but in cases where less than $2^n$ code words are used for coding, the kernel preferably is selected as the (n-1) bit word with the largest Hamming distance to the non-used code word(s),
- generating k new words, where $1 \leq k \leq (n-1)$, with the Hamming distance one to said kernel, said new words being placed at respective level distances $\mathbf{d} = [d_1, d_2 ... d_k]$ from the kernel, each of said respective level distances being distinct from any other distance and being any one integer in the range of $[1, 2^{(n-1)}-1]$, said level distances being arranged in an ordered sequence according to which the corresponding words are processed,
- the individual selection of said level distances $\mathbf{d} = [d_1, d_2 ... d_k]$ affecting the error distances d1(m) and d2(m) and being selected to match the probability density function in such a way that,
- choosing $\mathbf{d} = [1, 2, ..., (n-1)]$ will imply that the minimum error distances d1(m) and d2(m) are allocated towards the kernel with a peak at the kernel, and
- choosing $\mathbf{d} = [(n-1), (n-2), ..., 1]$ will imply that the minimum error distances d1(m) and d2(m) will have a wider distribution compared to the previous case, and
- choosing $\mathbf{d} = \mathbf{x}$ where $\mathbf{x}$ is a vector of k distinct elements in the range $[1, 2^{(n-1)}-1]$ units, with the design flexibility to move the minimum error distances d1(m) and d2(m) away from the kernel and where the minimum error distances occur in the region where the elements in x are compactly positioned;
- continuing to build the table, where the first word to consider is the one pointed to by $d_1$, hereafter called the first reference word;
- generating (n-1) new words with Hamming distance one to said first reference word and packing said (n-1) new words, if not already in the table, as close as possible to the kernel;
- selecting a second reference word pointed to by $d_2$;
- generating (n-1) new words with Hamming distance one to said second reference word and packing said (n-1) new words, if not already in the table, as close as. possible to the kernel;
- repetitively selecting new reference words pointed to by successive elements in d, until the last element $d_k$ is reached, and;
- generating (n-1) new words with Hamming distance one to current reference word and packing said (n-1) new words, if not already in the table, as close as possible to the kernel;
- completing the table in cases the table is not full (with $2^{(n-1)}$ words) after said initialisation process, by which repetitively the word closest to the kernel is taken as a reference word and
- generating (n-1) new words with Hamming distance one to current reference word packing said (n-1) new words, if not already in the table, as close as possible to the kernel;
- stopping new word generation when $2^{(n-1)}$ words have been generated;
- generating $2^{(n-1)}$ words by flipping the existing $2^{(n-1)}$ words up-down below the kernel;
- putting a one (or zero) in any column position in the first $2^{(n-1)}$ words and a zero (or one) in the same column position in the next $2^{(n-1)}$ words, whereby a code table with $2^n$ code words is generated, and;
- removing non-used code word(s), which with a suitable choice of the kernel as previously described, is (are) allocated towards the end(s) of the code table.

9. A method in accordance with claim 8, **characterized in that** the coded information is transmitted over a radio channel.

10. A method in accordance with claim 8, **characterized in that** the coded information is video information.

**Patentansprüche**

1. Verfahren zum Erzeugen eines robusten Codes fester Wortlänge zum Verschlüsseln von Information in einem Telekommunikationssystem
   **gekennzeichnet durch**
   Initialisieren einer Code-Tabelle **durch** Auswählen eines Kerncodeworts, Zuweisen des Kerncodeworts zu einer Position, die einem Spitzenwert einer Wahrscheinlichkeitsdichtefunktion der Information entspricht, wobei der Kern n Bits besitzt, Erzeugen von n neuen Codewörtern, von denen jedes einen Hamming-Abstand Eins von dem Kern besitzt, Packen der neuen Codewörter so nah wie möglich auf jeder Seite des Kerns, um die Code-Tabelle zu bilden.

2. Verfahren nach Anspruch 1,
   **gekennzeichnet durch**
   die weiteren Schritte:

   - Fortsetzen des Bildens der Tabelle, wobei ein erstes Codewort, das zu betrachten ist und das im folgenden als das erste Referenzwort bezeichnet wird, das dem Kern nächste Codewort ist, das entweder, wenn ungerade ist, auf der Seite des Kerns angeordnet ist, die die geringste Anzahl von initialisierten Codewörtern besitzt, oder, wenn n gerade ist, auf irgendeiner Seite des Kerns angeordnet ist,

   - Erzeugen von n neuen Codeworten mit Hamming-Abstand Eins zu dem ersten Referenzwort und Packen der n neuen Codewörter, falls noch nicht in der Tabelle, so nahe wie möglich zu dem ersten Referenzwort.

3. Verfahren nach Anspruch 2,
   **gekennzeichnet durch**
   die weiteren Schritte:

   - Auswählen eines zweiten Referenzworts von der noch nicht ausgewählten Seite des Kerns und so nahe wie möglich am Kern;

   - Generieren von n neuen Codewörtern mit Hamming-Abstand Eins zu dem zweiten Referenzwort und Packen der n neuen Codewörter, falls nicht bereits in der Tabelle, so nahe wie möglich an das zweite Referenzwort.

4. Verfahren nach Anspruch 3,
   **gekennzeichnet durch**
   die weiteren Schritte:

   - wiederholtes Auswählen neuer Referenzwörter so nahe wie möglich am Kern in abwechselnder Reihenfolge und mit zunehmendem Abstand zum Kern;

   - Erzugen von n neuen Codewörtern mit Hamming-Abstand Eins zu dem momentanen Referenzwort und Pakken der n neuen Codewörter, falls nicht bereits in der Tabelle, so nahe wie möglich zu dem momentanen Referenzwort.

5. Verfahren nach einem der vorangegangenen Ansprüche, bei dem weniger als $2^n$ Codewörter zum codieren verwendet werden,
   **gekennzeichnet durch**
   Auswählen des Kerns als das Codewort mit dem größen Hamming-Abstand zu den nicht verwendeten Codeworten.

6. Verfahren nach Anspruch 1, wobei die codierte Informtion über einen Funkkanal übertragen wird.

7. Verfahren nach Anspruch 1, wobei die übertragene Information Videoinformation ist.

8. Verfahren zum Erzeugen eines robusten Codes fester Wortlänge zum Verschlüsseln von Information in einem Telekommunikationssystem,
   **gekennzeichnet durch**

   - Initialisieren einer Codetabelle **durch** Auswählen eines Kerncodeworts und Zuweisen des Kerncodeworts zu

**EP 0 864 205 B1**

einer geschätzten oder realen Symmetrielinie der Wahrscheinlichkeitsdichtefunktion der Information,

- Auswählen des Kerns zufällig als ein (n-1)-Bitwort, wobei n die Anzahl der Bits in einem Codewort ist, aber in Fällen, in denen weniger als $2^n$-Codewörter für die Kodierung verwendet werden, wird der Kern vorzugsweise ausgewählt als das (n-1)-Bitwort mit dem größten Hamming-Abstand zu den nicht-verwendeten Codeworten,

- Generieren von k neuen Worten, mit $1 \le k \le (n-1)$ mit dem Hamming-Abstand Eins zu dem Kern, wobei die neuen Worte bei jeweiligen Stufenabständen $d = [d_1, d_2 ... d_k]$ von dem Kern plaziert werden, wobei jeder der jeweiligen Stufenabstände von jedem anderen Abstand verschieden ist und wobei irgendeine ganze Zahl im Bereich von $[1, 2^{(n-1)}-1]$ ist, wobei die Stufenabstände angeordnet sind in einer geordneten Sequenz, der entsprechend die korrespondierenden Worte verarbeitet werden,

- die individuelle Auswahl der Stufenabstände $d = [d_1, d_2 ... d_k]$, die die Fehlerabstände d1(m) und d2(m) beeinflussen und die ausgewählt sind, um zu der Wahrscheinlichkeitsdichtefunktion derart zu passen, dass

- Auswählen von $d = [1, 2, ..., (n-1)]$ impliziert, dass die minimale Fehlerabstände d1(m) und d2(m) zu dem Kern mit einem Spitzenwert bei dem Kern zugewiesen werden, und

- Auswählen von $d = [(n-1), (n-2), ..., 1]$ impliziert, dass die minimalen Fehlerabstände d1(m) und d2(m) eine weitere Verteilung haben im Vergleich zum vorherigen Fall, und

- Auswählen von $d = x$, wobei x ein Vektor aus k ausgeprägten Elementen in dem Bereich $[1, 2^{(n-1)}-1]$ Einheiten ist, mit der Entwurfsflexibilität, die minimalen Fehlerabstände d1(m) und d2(m) von dem Kern wegzubewegen und wobei die minimalen Fehlerabstände in dem Bereich auftreten, in dem die Elemente in x kompakt positioniert sind;

- Fortsetzen des Bildens der Tabelle, wobei das erste zu betrachtende Wort dasjenige ist, worauf $d_1$ zeigt, im folgenden als erstes Referenzwort bezeichnet;

- Erzeugen von (n-1) neuen Worten mit Hamming-Abstand Eins zu dem ersten Referenzwort und Packen der (n-1) neuen Worte, falls nicht bereits in der Tabelle so nahe wie möglich zu dem Kern;

- Auswählen eines zweiten Referenzworts, auf das $d_2$ zeigt;

- Erzeugen von (n-1) neuen Worten mit Hamming-Abstand Eins zu dem zweiten Referenzwort und Packen der (n-1) neuen Worte, falls nicht bereits in der Tabelle, so nahe wie möglich zu dem Kern,

- Wiederholtes Auswählen neuer Referenzworte, auf die aufeinanderfolgende Elemente in d zeigen, bis das letzte Element $d_k$ erreicht ist, und

- Erzeugen von (n-1) neuen Worten mit Hamming-Abstand Eins zu dem jeweiligen Referenzwort und Packen der (n-1) neuen Worte, falls nicht bereits in der Tabelle, so nahe wie möglich zu dem Kern,

- Vervollständigen der Tabelle in den Fällen, in denen die Tabelle nicht gefüllt ist (mit $2^{(n-1)}$ Worten) nach dem Initialisierungsprozess, **durch** den das Wort am nächsten zum Kern als Referenzwort genommen wird, und

- Erzeugen von (n-1) neuen Worten mit Hamming-Abstand Eins zu dem momentanen Referenzwort und Packen der (n-1) neuen Worte, falls nicht bereits in der Tabelle, so nahe wie möglich zum Kern;

- Anhalten der Erzeugung neuer Worte, wenn $2^{(n-1)}$ Worte erzeugt worden sind;

- Erzeugen von $2^{(n-1)}$ Worten **durch** Umdrehen der existierenden $2^{(n-1)}$ Worte von oben nach unten unterhalb des Kerns;

- Einstellen einer 1 (oder 0) in jeder Spaltenposition in den ersten $2^{(n-1)}$ Worten und einer 0 (oder 1) in denselben Spaltenpositionen in den nächsten $2^{(n-1)}$ Worten, wobei eine Codetabelle mit $2^n$ Codeworten erzeugt wird, und

- Entfernen von einem nicht-verwendeten Codewort / nicht verwendeten Codewörtern, das/die einer geeigneten

13

Auswahl des Kerns, wie zuvor beschrieben, zugewiesen wird / zugewiesen werden zu dem Ende / den Enden der Codetabelle.

**9.** Verfahren nach Anspruch 8,
**dadurch gekennzeichnet, dass**
die codierte Information über einen Funkkanal übertragen wird.

**10.** Verfahren nach Anspruch 8,
**dadurch gekennzeichnet, dass**
die codierte Informatin Videoinformation ist.

**Revendications**

**1.** Procédé pour générer un code de longueur fixe robuste pour coder des informations dans un système de télécommunication, **caractérisé par** le fait d'initialiser une table de code en sélectionnant un mot de code de noyau, d'allouer le mode de code de noyau à une position correspondant à un pic d'une fonction de densité de probabilité des informations, ledit noyau étant à n bits, de générer n nouveaux mots de code, chaque nouveau mot de code ayant une distance de Hamming de un par rapport audit noyau, de compacter lesdits nouveaux mots de code de façon qu'ils soient aussi près que possible de part et d'autre du noyau afin de construire ladite table de code.

**2.** Procédé selon la revendication 1, **caractérisé par** les étapes supplémentaires consistant à :

- continuer de construire la table, un premier mot de code considéré, désigné ci-après premier mot de référence, étant le mot de code le plus proche du noyau qui est soit situé, lorsque n est impair, du côté du noyau qui correspond au nombre le plus faible de mots de code initialisé, soit situé, lorsque n est pair, d'un côté quelconque du noyau ;
- générer n nouveaux mots de code avec une distance de Hamming de un par rapport audit premier mot de référence et compacter lesdits n nouveaux mots de code qui ne sont pas déjà dans la table, aussi près que possible dudit premier mot de référence.

**3.** Procédé selon la revendication 2, **caractérisé par** les étapes supplémentaires consistant à :

- sélectionner un second mot de référence en provenance du côté non encore sélectionné du hoyau et de façon qu'il soit aussi près que possible du noyau ;
- générer n nouveaux mots de code avec une distance de Hamming de un par rapport audit mot de référence et compacter lesdits n nouveaux mots de code, s'ils ne sont pas déjà dans la table, de façon qu'ils soient aussi près que possible dudit second mot de référence.

**4.** Procédé selon la revendication 3, **caractérisé par** les étapes supplémentaires consistant à :

- sélectionner de façon répétitive de nouveaux mots de référence de façon qu'ils soient aussi près que possible du noyau dans un ordre alterné et à une distance croissante du noyau ;
- générer n nouveaux mots de code avec une distance de Hamming de un par rapport audit mot de référence courant et compacter lesdits n nouveaux mots de code s'ils ne sont pas déjà dans la table, de façon qu'ils soient aussi près que possible dudit mot de référence courant.

**5.** Procédé selon l'une quelconque des revendications précédentes, dans lequel moins de $2^n$ mots de code sont utilisés pour le codage, **caractérisé par** le fait de sélectionner le noyau en tant que mot de code ayant la distance de Hamming la plus grande par rapport aux mots de code non utilisés.

**6.** Procédé selon la revendication 1, dans lequel les informations codées sont transmises par l'intermédiaire d'un canal radio.

**7.** Procédé selon la revendication 1, dans lequel les informations transmises sont des informations vidéo.

**8.** Procédé pour générer un code de longueur fixe robuste pour coder des informations dans un système de télécommunication, **caractérisé par le fait qu'**il consiste à :

- initialiser une table de code en sélectionnant un mot de code de noyau et en affectant le mot de code de noyau à une ligne de symétrie estimée ou réelle d'une fonction de densité de probabilité des informations ;
- sélectionner le noyau de façon arbitraire en tant que mot à (n-1) bits, n étant le nombre de bits d'un mot de code, et dans le cas où moins de $2^n$ mots de code sont utilisés pour le codage, le noyau est de préférence sélectionné en tant que mot à (n-1) bits ayant la distance de Hamming la plus grande par rapport au(x) mot (s) de code non utilisé(s),
- générer k nouveaux mots, où $1 \leq k \leq (n-1)$, ayant la distance de Hamming de un par rapport audit noyau, lesdits nouveaux mots de code étant placés à des distances de niveaux respectives d= $[d_1, d_2, ... d_k]$ du noyau, chacune desdites distances de niveaux respectives étant distincte de l'une quelconque des autres distances et étant un entier quelconque dans l'intervalle $[1, 2^{(n-1)}-1]$, lesdites distances de niveaux étant agencées dans une séquence ordonnée en fonction de laquelle les mots correspondants sont traités,
- la sélection individuelle desdites distances de niveaux **d**=$[d_1, d_2, ... d_k]$ affectant les distances d'erreurs d1(m) et d2(m) et cette distance étant sélectionnée de façon à faire concorder la fonction de densité de probabilité de telle manière que :

- le choix de **d**= $[1, 2, ..., (n-1)]$ implique que les distances d'erreurs minimales d1(m) et d2(m) sont allouées au noyau avec un pic à l'emplacement du noyau, et
- le choix de **d**=$[(n-1), (n-2), ..., 1]$ implique que les distances d'erreurs minimales d1(m) et d2(m) ont une distribution plus large par comparaison au cas précédent, et
- le choix de **d=x**, où **x** est un vecteur de k éléments distincts dans l'intervalle $[1, 2^{(n-1)}-1]$ unités, offrant une souplesse de conception selon laquelle on peut éloigner les distances d'erreurs minimales d1(m) et d2(m) du noyau et selon laquelle les distances d'erreurs minimales apparaissent dans la région où les éléments de x sont disposés de façon compacte ;
- continuer de construire la table, le premier mot à prendre en considération étant celui sur lequel pointe $d_1$, celui-ci étant désigné ci-après premier mot de référence,
- générer (n-1) nouveaux mots ayant une distance de Hamming de un par rapport audit premier mot de référence et compacter lesdits (n-1) nouveaux mots s'ils ne sont pas déjà dans la table, afin qu'ils soient aussi près que possible du noyau ;
- sélectionner un second mot de référence sur lequel pointe $d_2$ ;
- générer (n-1) nouveaux mots de code ayant une distance de Hamming de un par rapport audit second mot de référence et compacter lesdits (n-1) nouveaux mots, s'ils ne sont pas déjà dans la table, de façon qu'ils soient aussi près que possible du noyau ;
- sélectionner de façon répétitive des nouveaux mots de référence sur lesquels pointent des éléments successifs de d, jusqu'à ce que le dernier élément $d_k$ soit atteint ; et
- générer (n-1) nouveaux mots de code ayant une distance de Hamming de un par rapport au mot de référence courant et compacter lesdits (n-1) nouveaux mots, s'ils ne sont pas déjà dans la table, de façon qu'ils soient aussi près que possible du noyau ;
- compléter la table dans des cas où la table n'est pas pleine (avec $2^{(n-1)}$ mots) après ledit processus d'initialisation, en prenant de façon répétitive le mot le plus proche du noyau comme mot de référence et
- générer (n-1) nouveaux mots ayant une distance de Hamming de un par rapport au mot de référence courant en compactant lesdits (n-1) nouveaux mots, s'ils ne sont pas déjà dans la table, de façon qu'ils soient aussi près que possible du noyau ;
- interrompre la création du nouveau mot lorsque $2^{(n-1)}$ mots ont été générés ;
- générer $2^{(n-1)}$ mots en renversant l'ordre des $2^{(n-1)}$ mots existants en dessous du noyau ;
- placer un un (ou un zéro) à une position de colonne quelconque dans les $2^{(n-1)}$ premiers mots et un zéro (ou un un) à la même position de colonne dans les $2^{(n-1)}$ mots suivants, une table de code à $2^n$ mots de code étant ainsi générée ; et
- éliminer le(s) mot(s) de code non utilisé(s) qui, par un choix approprié du noyau de la façon décrite précédemment, est (sont) alloué(s) à la ou aux extrémité(s) de la table de code.

9. Procédé selon la revendication 8, **caractérisé en ce que** les informations codées sont transmises par l'intermédiaire d'un canal radio.

10. Procédé selon la revendication 8, **caractérisé en ce que** les informations codées sont des informations vidéo.

0.1 X

0.0 X

1.1 X

1.0 X

FIG. 1

FIG. 2

FIG. 3